Europäisches Patentamt

(19) European Patent Office

Office européen des brevets

(11) Publication number: **0 104 094**

**B1**

(12) **EUROPEAN PATENT SPECIFICATION**

(45) Date of publication of patent specification: **30.12.86**

(21) Application number: **83305602.1**

(22) Date of filing: **21.09.83**

(51) Int. Cl.⁴: **H 01 L 21/28,** H 01 L 29/64

(54) **Method of producing a semiconductor device, using a radiation-sensitive resist.**

(30) Priority: **21.09.82 JP 163063/82**

(43) Date of publication of application:
**28.03.84 Bulletin 84/13**

(45) Publication of the grant of the patent:
**30.12.86 Bulletin 86/52**

(84) Designated Contracting States:
**DE FR GB**

(56) References cited:
**US-A-3 951 708**
**US-A-4 341 850**

**Patent Abstracts of Japan Vol. 2, no. 90, 22 July 1978 Page 4183E78 & JP-A-53-54979**

(73) Proprietor: **FUJITSU LIMITED**
**1015, Kamikodanaka Nakahara-ku Kawasaki-shi Kanagawa 211 (JP)**

(72) Inventor: **Kosemura, Kinjiro**
**2854-1-805, liyama**
**Atsugi-shi Kanagawa 243-02 (JP)**
Inventor: **Yamashita, Yoshimi**
**2-8-2-104, Bunkyo**
**Sagamihara-shi Kanagawa 228 (JP)**
Inventor: **Nakayama, Noriaki**
**9-24-306, Satsuki-cho**
**Ebina-shi Kanagawa 243-04 (JP)**
Inventor: **Yamamoto, Sumio**
**51-1, Oguchi-nakamachi Kanagawa-ku Yokohama-shi Kanagawa 221 (JP)**

(74) Representative: **Fane, Christopher Robin King et al**
**HASELTINE LAKE & CO. Hazlitt House 28 Southampton Buildings Chancery Lane London, WC2A 1AT (GB)**

Courier Press, Leamington Spa, England.

## Description

The present invention relates to a method of producing a semiconductor device, using a radiation-sensitive resist, for example for use in producing a Schottky barrier type field effect transistor (FET) having a semiconductor layer of gallium arsenide (GaAs) as an active layer.

Schottky barrier type FET's using a semiconductor layer consisting of GaAs as an active layer (GaAs FET's) have been coming into increasing use due to their high frequency, high power, and high efficiency. Such a high-performance GaAs FET may, for example, be achieved by a recess structure, in which the part of the GaAs active layer where a gate electrode is arranged is thinned. Further, an offset structure may be employed, in which the source electrode is arranged close to the gate electrode (see e.g. JP—A—5354979).

Such recess and offset structures can be employed to achieve decreased series resistance between the source electrode and the gate electrode, improvement of the transconductance, and suitability for high frequency and high power applications. Further, by making the distance on the side of the drain electrode greater the Schottky withstand voltage between the gate electrode and the drain electrode can be increased, so that the gate current is decreased during the operation thereof, with the result that danger of electromigration is reduced.

In the recess structure, one shortens the recess width in an attempt to improve the above characteristics, the gate electrode being formed centrally in the recess. However, the closer the widths of the recess and gate electrode, the greater the difficulty of extending the depletion layer, whereby a high electric field is formed and the Schottky withstand voltage between the gate electrode and drain electrode is reduced. Further, when the Schottky withstand voltage is reduced, the operating gate current (1g) of the FET is increased, whereby electromigration of the gate electrode may occur, and the life of the FET may be unduly shortened.

To improve the Schottky withstand voltage, there has been proposed a method for lowering carrier concentration in an active layer. However, when the carrier concentration in the active layer is lowered the transconductance is decreased and an FET having sufficiently high performance is not obtained.

It is desirable to provide a method for producing a field effect type semiconductor device wherein the series resistance between a source electrode and a gate electrode is decreased, relative to a comparable prior art device, while the Schottky withstand voltage between the gate electrode and a drain electrode is maintained.

In the method according to the present invention a resist layer on a semiconductor active layer is subjected to a two-step exposure: in one step a portion of the resist is irradiated so that on development a corresponding opening is formed in the resist layer corresponding to a desired gate electrode, and in the other step an adjacent portion of the resist is irradiated so that on development only the lower portion of the opening is correspondingly enlarged. Thus, on subsequently etching the semiconductor active layer using the resist layer as a mask, the recess is located eccentrically with respect to the opening and to a gate electrode that may be formed as an additional element of the device by deposition of material through the opening on to the recess.

Thus, according to the present invention a method for producing a field effect type semiconductor device comprises the steps of: forming a semiconductor active layer on a substrate; forming source and drain electrodes on the semiconductor active layer; forming a resist layer on the semiconductor active layer and the source and drain electrodes; exposing a first portion of the resist layer in accordance with a gate electrode pattern; carrying out auxiliary exposure of a second portion of the resist layer adjacent the first portion after or before the exposure of the first portion; developing the exposed resist layer; the steps of forming, exposing and developing the resist layer being such that the developing process forms an upper opening of the resist layer in accordance with the gate electrode pattern and a lower opening of the resist layer in accordance with the exposure of the first and second portions, the cross-section of the opening of the resist layer in the source-drain direction being asymmetrically enlarged by the developing process in the area near the drain electrode; forming a recess in the semiconductor active layer by etching the exposed semiconductor active layer through the lower opening of the resist layer using the resist layer as a mask, the recess having an asymmetric structure and being enlarged, with respect to the upper opening, in the area near the drain electrode; and forming a gate electrode on the surface of the recess using the resist layer as a mask, the position of the gate electrode being closer to the source electrode than to the drain electrode and being aligned with the edges of the upper opening.

Reference will now be made, by way of example, to the accompanying drawings, in which:

Figs. 1A to 1G are cross-sectional views of an embodiment of a production process according to the present invention and

Fig. 2 is a graph explaining the relation between the recess length and the Schottky withstand voltage; and

Figs. 3 and 4 are cross-sectional views of processes for forming a resist layer on a semiconductor active layer, embodying the present invention.

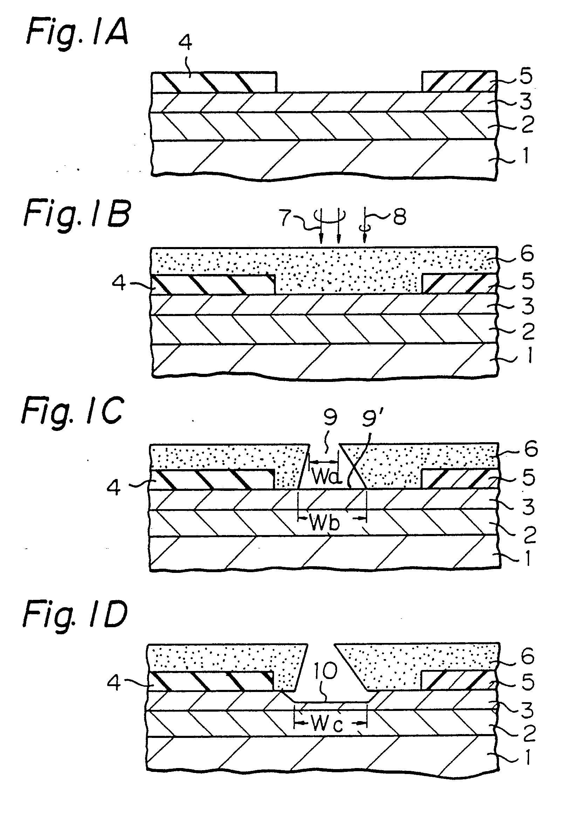

Figures 1A to 1G are cross-sectional views of an embodiment of a production process according to the present invention.

In Fig. 1A, a semiconductor substrate, for example, a semi-insulating GaAs substrate 1 is first prepared. An intrinsic GaAs layer 2 having a thickness of 3 to 5 µm is then formed on it as a buffer layer by a well known chemical vapor deposition process. Then an N-type GaAs active layer 3 having a thickness of 0.3 to 0.5 µm is formed on the GaAs buffer layer 2, by a CVD process. The N-type GaAs layer 3 includes impurity ions, for example, sulfur ions of $1—3 \times 10^{17}$ atom/cm$^3$, and acts as a semiconductor active layer.

A source electrode 4 and a drain electrode 5 are formed on the N-type GaAs active layer 3 a short distance from each other, for example, 4 to 5 µm, by a vapor deposition process and a selective etching process. The electrodes 4 and 5 are double layer types composed of an alloy layer consisting of 88 wt% gold and 12 wt% germanium and a gold layer formed on the alloy layer. The total thickness of the double layer is 400 to 500 nm (4000 to 5000 angstrom). The electrodes 4 and 5 are heat treated at a temperature of approximately 450°C to create ohmic contact between the electrodes 4 and 5 and the GaAs active layer 3.

Referring to Fig. 1B, a resist layer 6, for example, a positive resist layer for electron beam exposure such as CMR-100 (brand-name of Fujitsu), is next formed over the exposed surfaces of the source and drain electrodes 4 and 5 and the GaAs active layer 3 by means of a spinner (not shown). After forming the resist layer 6, a baking treatment is carried out at a temperature of approximately 190°C.

The two-step exposure may then be performed by selectively irradiating a first portion of the surface of the resist layer 6, i.e., the portion closer to the source electrode 4 than to the drain electrode 5, with a first electron beam 7 to expose a gate electrode pattern. The first electron beam irradiation is preferably carried out under an accelerated voltage of 20 KV, a beam current of 1 to 10 nA, for example, 2.5 nA, a frequency of 14 to 130 kHz, for example, 35.35 kHz, a beam dosage of 4 to $10 \times 10^{-4}$ c/cm$^2$, for example, $4.53 \times 10^{-4}$ c/cm$^2$, and 1 to 5 passes, for example, one pass.

After the first electron beam irradiation, a second electron beam 8 is irradiated to a second portion of the resist layer adjacent the first portion, for example, 0.75 µm from the center of the first portion, the second portion being nearer to the drain electrode 5 than to the source electrode 4. The second electron beam irradiation is preferably carried out under the same accelerated voltage and beam current as the first electron beam irradiation, a frequency of 53 to 160 kHz, for example, 77.00 kHz, a beam dosage of 1 to $3 \times 10^{-4}$ c/cm$^2$, for example; $2.08 \times 10^{-4}$ c/cm$^2$, and 1 to 5 passes, for example, one pass.

Referring now to Fig. 1C, the resist layer 6 is then developed, e.g. by methylisobutyl ketone. A hollow having an upper opening 9 and bottom opening 9' is thereby formed in the resist in accordance with the pattern exposed by the first and the second electron beams 7 and 8, the hollow in the resist layer 6 becoming gradually larger towards the GaAs active layer 3 and having an asymmetric cross-section, i.e., the side near the drain electrode 5 being larger than that near the source electrode 4.

Referring to Fig. 1D, the GaAs active layer 3 is next selectively etched by wet etching process using an etchant of hydrofluoric acid system and using the resist 6 as a mask to form a recess 10. The width and the depth of the recess 10 are determined by calculating the electric properties of the related FET. The bottom width Wc of the recess 10 equals to the bottom width Wb (9') (Fig. 1C) of the hollow. Embodiments of the present invention can allow the width of the upper opening Wa, the bottom width Wb (9') of the hollow in the resist layer 6, and the bottom width Wc of the recess 10 to be controlled by controlling the first exposure and second exposure.

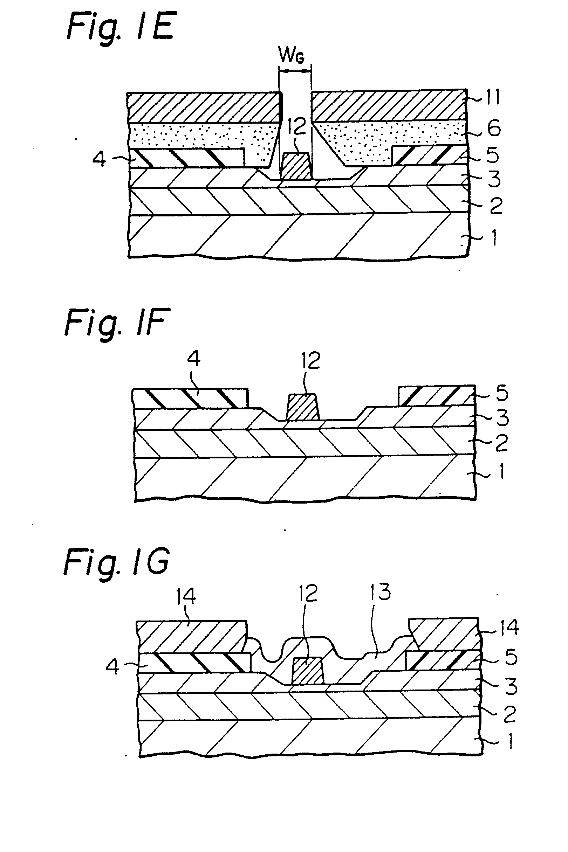

Then, as shown in Fig. 1E, a gate metal, for example, aluminum, is vapor-deposited using the resist layer 6 as a mask to form gate metal layers 11 and 12 having a thickness of about 0.7 µm on the resist layer 6 and the recess 10. Since the hollow of the resist layer 6 is larger the closer the GaAs active layer 3, the gate metal layers 11 and 12 are easily formed completely separate from each other. The width of the gate metal layer 12 i.e., gate width $W_G$, is substantially equal to the width Wa (Fig. 1C) of the hollow.

Then, as shown in Fig. 1F the resist layer 6 is removed by, for example, chemicals, lifting off the gate metal layer 11. This leaves the gate metal layer 12 as the gate electrode. For example, the gate electrode can be placed at a position shifted from mid line of source and drain electrodes by 0.5 µm toward the source electrode.

Referring to Fig. 1G, the exposed surfaces of the gate metal layer 12, the source electrode 4, the drain electrode 5, and the GaAs active layer 3 are covered with an insulating layer 13, for example a silicon dioxide layer, which acts as a passivation layer and has a thickness of, for example, 500 to 600 nm (5000 to 6000 angstrom). The insulating layer 13 is formed by well known chemical vapor deposition process or a sputtering process. The part of the insulating layer 13 on the source electrode 4 and the drain electrode 5 is selectively removed, and a plated gold layer 14 having a thickness of 0.5 to 2 µm is formed on the source and drain electrodes 4 and 5 by using the insulating layer 13.

Thus, a GaAs FET can be produced by a method embodying the present invention.

When a gate electrode is formed on a recess, in the conventional method, the resist layer is developed by electron beam irradiation only at one portion. Thus, the hollow in the resist layer becomes gradually larger the closer to the GaAs active layer and has a symmetric cross-section. On the contrary, in the described embodiment the resist layer is developed by electron beam irradiation at two portions, i.e., the first and the second exposure, as explained above. Thus, the hollow in the resist both becomes gradually larger the closer to the GaAs active layer and has an asymmetric cross-section, i.e., the nearer the drain electrode, the larger the cross-sectional area of the hollow.

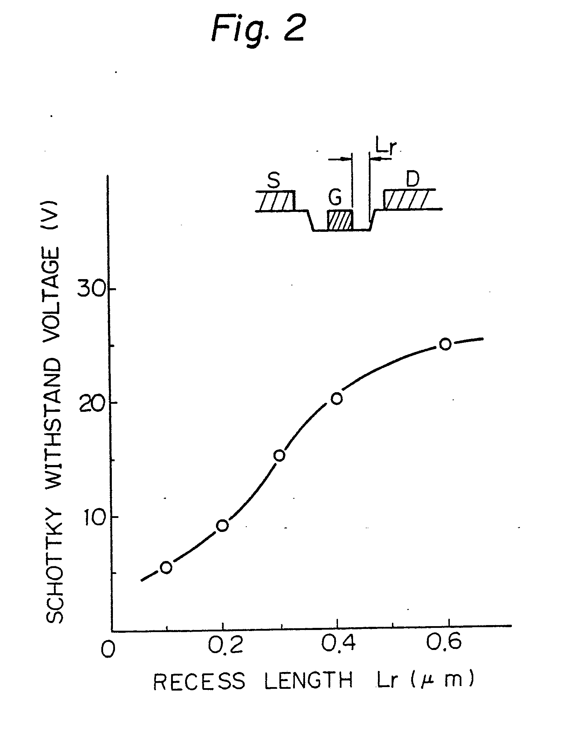

Therefore, as described above, the gate electrode can be formed much closer to the source electrode side than to the drain gate electrode side, with the result that the series resistance between the source electrode and the gate electrode can be decreased. Furthermore, as shown in Fig. 2, the Schottky withstand voltage can be improved when the recess length Lr is increased. The conventional recess length Lr is at most 0.2 μm, thus the Schottky withstand voltage is 8V, as shown in Fig. 2. However in embodiments of the present invention the recess length Lr can be 0.6 μm. Thus the Schottky withstand voltage can be improved, so that the value of the voltage becomes 25V, with the result that the gate current is decreased during the operation thereof and electromigration can also be prevented. Using such embodiments, a high power and high efficiency MES FET can be obtained.

The second exposure of the resist layer may be carried out before the first exposure. The second exposure of the resist layer may be carried out in such manner that some part of the second exposure of the resist layer is doubled by the first exposure of the resist layer.

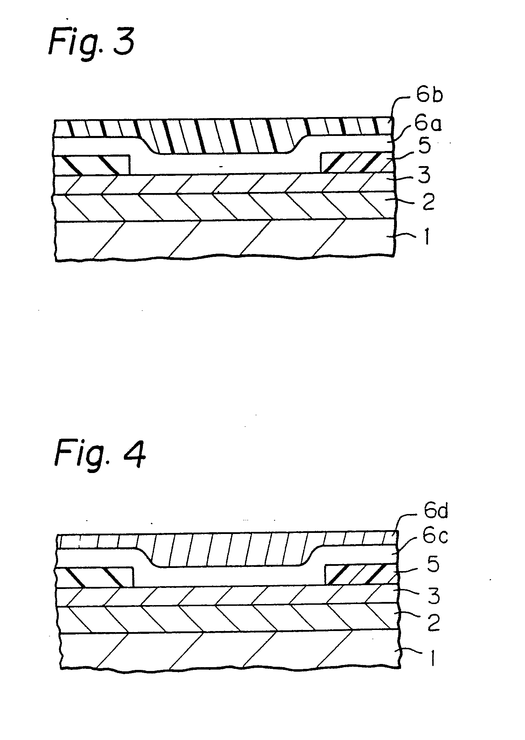

It is preferable to use a combination of resist layers. For example, as in Fig. 3, there may be provided a resist layer 6a which has a greater sensitivity, for example, CMR-100 and a resist layer 6b which has a less sensitivity, for example, OEBR-1000 (brandname of Tokyo Ohka), the resist layer 6b being provided on the resist 6a. Alternatively, as in Fig. 4, there may be provided a resist layer 6c which is pre-exposed on the entire surface thereof and a resist layer 6d, the resist layers 6c and 6d being, for example, CMR-100. By using the above two type resist layers, the asymmetrical hollow in the resist can be easily formed.

Embodiments of the invention can be used to form, for example, a Metal Schottky (MES) GaAs or InP FET, MIS GaAs or InP FET, or Heterojunction FET such as High Electron Mobility Transistor (HEMT) proposed by the assignee of this application.

**Claims**

1. A method for producing a field effect type semiconductor device comprising the steps of:

(a) forming a semiconductor active layer on a substrate;

(b) forming source and drain electrodes on the semiconductor active layer;

(c) forming a resist layer on the semiconductor active layer and the source and drain electrodes;

(d) exposing a first portion of the resist layer in accordance with a gate electrode pattern;

(e) carrying out auxiliary exposure of a second portion of the resist layer adjacent the first portion after or before the exposure of the first portion of the resist layer in said step (d);

(f) developing the exposed resist layer; the steps of forming, exposing and developing the resist layer being such that the developing process forms an upper opening of the resist layer in accordance with the gate electrode pattern and a lower opening of the resist layer in accordance with the exposure of the first and second portions, the cross-section of the opening of the resist layer in the source-drain direction being asymmetrically enlarged by the developing process in the area near the drain electrode;

(g) forming a recess in the semiconductor active layer by etching the exposed semiconductor active layer through the lower opening of the resist layer using the resist layer as a mask, the recess having an asymmetric structure and being enlarged, with respect to the upper opening, in the area near the drain electrode; and

(h) forming a gate electrode on the surface of the recess using the resist layer as a mask, the position of the gate electrode being closer to the source electrode than to the drain electrode and being aligned with the edges of the upper opening.

2. A method according to claim 1, wherein said resist layer is composed of double layer consisting of a more sensitive resist layer and a less sensitive resist layer provided on said more sensitive resist layer.

3. A method according to claim 1, wherein said resist layer is composed of a double layer consisting of a first resist layer and a second resist layer provided on the first layer, the first resist layer being pre-exposed.

4. A method according to claim 1, 2 or 3, wherein said first and second exposure of said resist layer are carried out by irradiating an electron beam.

5. A method according to claim 4, wherein an exposure frequency of 14 to 130 kHz is used in said first exposure.

6. A method according to claim 4 to 5, wherein an exposure frequency of 53 to 160 kHz is used in said second exposure.

7. A method according to claim 4, 5 or 6, wherein an electron beam dosage of 4 to $10 \times 10^{-4}$ c/cm² is used in said first exposure.

8. A method according to claim 4, 5, 6 or 7, wherein an electron beam dosage of 1 to $3 \times 10^{-4}$ c/cm² is used in said second exposure.

9. A method of producing a semiconductor device, wherein a layer (6) of resist is formed on a surface of a semiconductor layer (3), the resist layer is exposed to a pattern of radiation of a kind to which the resist is sensitive and is then subjected to a development process for removing a portion thereof that is defined by the said pattern, and the said semiconductor layer is etched through a gap (9) left by the removal of the said portion of the resist layer so as to form a recess (10) in the semiconductor layer, whereafter material (12) is deposited on the semiconductor layer in the recess to form an additional element of the device, characterised in that the exposure of the resist layer is carried out in two stages, employing respective beams (7, 8) of radiation the areas of incidence whereof on the resist layer are adjacent, such that the development process causes the resist layer to be undercut, where it bounds the said gap, to a greater extent in one direction (over the surface of the semiconductor layer) than in the opposite direction; the resist layer being then used as a mask in the deposition of the said material (12) so as to locate the said additional element eccentrically with respect to the said recess.

**Revendications**

1. Procédé de production d'un composant semi-conducteur du type à effet de champ, consistant:

(a) à former une couche active semi-conductrice sur un substrat;

(b) à former des électrodes de source et de drain sur la couche active semi-conductrice;

(c) à former une couche de matière de réserve sur la couche active semi-conductrice et les électrodes de source et de drain;

(d) à exposer une première partie de la couche de matière de réserve en fonction d'une configuration d'électrode de grille;

(e) à effectuer une exposition auxiliaire d'une seconde partie de la couche de matière de réserve près de la première partie après ou avant l'exposition de la première partie de la couche de matière de réserve dans l'opération (d);

(f) à développer la couche de matière de réserve exposée; les opérations de formation, d'exposition et de développement de la couche de matière de réserve étant telles que l'opération de développement forme une ouverture supérieure de la couche de matière de réserve en fonction de la configuration d'électrode de grille et une ouverture inférieure de la couche de matière de réserve en fonction de l'exposition de la première et de la seconde partie, la section de l'ouverture de la couche de matière de réserve dans la direction source-drain étant augmentée de façon dissymétrique par l'opération de développement dans la région voisine de l'électrode de drain;

(g) à former un logement dans la couche active semi-conductrice par gravure de la couche active semi-conductrice exposée à travers l'ouverture inférieure de la couche de matière de réserve en utilisant la matière de réserve comme un masque, le logement ayant une structure dissymétrique et étant agrandi par rapport à l'ouverture supérieure, dans la région voisine de l'électrode de drain, et

(h) à former une électrode de grille sur la surface du logement en utilisant la couche de matière de réserve comme un masque, la position de l'électrode de grille étant plus proche de l'électrode de source que de l'électrode de drain et étant alignée avec les bords de l'ouverture supérieure.

2. Procédé selon la revendication 1, dans lequel ladite couche de matière de réserve est constituée par une double couche consistant en une couche de matière de réserve plus sensible et une couche de matière de réserve moins sensible formée sur ladite couche de matière de réserve plus sensible.

3. Procédé selon la revendication 1, dans lequel ladite couche de matière de réserve est constituée par une double couche consistant en une première couche de matière de réserve et une seconde couche de matière de réserve prévue sur la première couche, la première couche de matière de réserve étant exposée préalablement.

4. Procédé selon la revendication 1, 2 ou 3, dans lequel ladite première et ladite seconde exposition de ladite couche de matière de réserve sont effectuées par irradiations avec un faisceau d'électrons.

5. Procédé selon la revendication 4, dans lequel une fréquence d'exposition de 14 à 130 kHz est utilisée dans ladite première exposition.

6. Procédé selon la revendication 4 ou 5, dans lequel une fréquence d'exposition de 53 à 160 kHz est utilisée dans ladite seconde exposition.

7. Procédé selon la revendications 4, 5 ou 6 dans lequel un dosage du faisceau d'électrons de 4 à $10 \times 10^{-4}$ c/cm$^2$ est utilisé dans la première exposition.

8. Procédé selon la revendication 4, 5, 6 ou 7 dans lequel un dosage du faisceau d'électron de 1 à $3 \times 10^{-4}$ c/cm$^2$ est utilisé dans ladite seconde exposition.

9. Procédé de production d'un composant semi-conducteur dans lequel une couche (6) de matière de réserve est formée sur une surface d'une couche semi-conductrice (3), la couche de matière de réserve étant exposée à une configuration de rayonnement d'un type auquel la matière de réserve est sensible, et soumis ensuite à un procédé de développement pour éliminer une partie qui est définie par ladite configuration, ladite couche semi-conductrice étant gravée dans un intervalle (9) laissé par l'enlèvement de ladite partie de ladite couche de matière de réserve de manière à former un logement (10) dans la couche semi-conductrice, une matière (12) étant ensuite déposée sur la couche semi-conductrice dans le logement pour former un élément supplémentaire du composant, caractérisé en ce que l'exposition de la couche de matière de réserve est effectuée en deux phases, en utilisant des faisceaux respectifs (7, 8) de rayonnement dont les surfaces d'incidence sur la couche de matière de réserve sont voisines, de manière que l'opération de développement entraine que la couche de matière de réserve soit en dépouille lorsqu'elle rejoint ledit intervalle, dans une plus grande mesure dans une direction (sur la surface de la couche semi-conductrice) que dans la direction opposée, la couche de matière étant ensuite utilisée comme un masque pour le dépot de ladite matière (12) de manière à disposer ledit élément supplémentaire excentriquement par rapport audit logement.

**Patentansprüche**

1. Verfahren zur Herstellung einer Feldeffekthalbleitervorrichtung, mit den folgenden Schritten:

(a) Bildung einer aktiven Halbleiterschicht auf einem Substrat;

(b) Bildung von Source- und Drainelektroden auf der aktiven Halbleiterschicht;

(c) Bildung einer Resistschicht auf der aktiven Halbleiterschicht und den Source- und Drainelektroden;

(d) Exponieren eines ersten Abschnittes der Resistschicht in Übereinstimmung mit einem Gateelektrodenmuster;

(e) Ausführen einer Hilfsexponierung eines zweiten Abschnitts der Resistschicht, der an den ersten Abschnitt angrenzt, nach oder vor der Exponierung des ersten Abschnitts der Resistschicht in dem genannten Schritt (d);

(f) Entwicklung der exponierten Resistschicht; wobei die Schritte der Bildung, der Exponierung und der Entwicklung der Resistschicht so sind, daß das Entwicklungsverfahren eine obere Öffnung der Resistschicht in Übereinstimmung mit dem Gateelektrodenmuster und eine untere Öffnung der Resistschicht in Übereinstimmung mit der Exponierung der ersten und zweiten Abschnitte bildet, wobei der Querschnitt der Öffnung der Resistschicht in Source-Drain-Richtung durch den Entwicklungsprozeß in dem Bereich nahe der Drainelektrode asymmetrisch vergrößert wird;

(g) Bildung einer Ausnehmung in der aktiven Halbleiterschicht durch Ätzen der exponierten aktiven Halbleiterschicht durch die untere Öffnung der Resistschicht unter Verwendung der Resistschicht als eine Maske, wobei die Ausnehmung eine asymmetrische Struktur hat und in dem Bereich nahe der Drainelektrode in Bezug auf die obere Öffnung vergrößert wird; und

(h) Bildung einer Gateelektrode auf der Oberfläche der Ausnehmung unter Verwendung der Resistschicht als eine Maske, wobei die Position der Gateelektrode dichter an der Sourceelektrode als an der Drainelektrode und mit den Rändern der oberen Öffnung ausgerichtet ist.

2. Verfahren nach Anspruch 1, bei welchem die genannte Resistschicht aus einer doppelten Schicht zusammengesetzt wird, die aus einer empfindlicheren Resistschicht und einer weniger empfindlichen Resistschicht besteht, die auf der genannten empfindlicheren Resistschicht vorgesehen wird.

3. Verfahren nach Anspruch 1, bei welchem die genannte Resistschicht aus einer doppelten Schicht zusammengesetzt wird, die aus einer ersten Resistschicht und aus einer zweiten Resistschicht, die auf der ersten Schicht vorgesehen wird, besteht, wobei die erste Resistschicht präexponiert wird.

4. Verfahren nach Anspruch 1, 2 oder 3, bei welchem die genannte erste und zweite Exponierung der genannten Resistschicht durch Bestrahlung mit einem Elektronenstrahl durchgeführt wird.

5. Verfahren nach Anspruch 4, bei welchem eine Exponierungsfrequenz von 14 bis 130 kHz bei der genannten ersten Exponierung verwendet wird.

6. Verfahren nach Anspruch 4 oder 5, bei welchem eine Exponierungsfrequenz von 53 vis 160 kHz während der zweiten Exponierung verwendet wird.

7. Verfahren nach Anspruch 4, 5 oder 6, bei welchem eine Elektronenstrahldosis von 4 bis $10 \times 10^4$ c/cm$^2$ während der genannten ersten Exponierung verwendet wird.

8. Verfahren nach Anspruch 4, 5, 6 oder 7, bei welchem eine Elektronenstrahldosis von 1 bis $3 \times 10^{-4}$ c/cm$^2$ bei der genannten zweiten Exponierung verwendet wird.

9. Verfahren zur Herstellung einer Halbleitervorrichtung, bei welchem eine erste Schicht (6) aus einem Resist auf einer Oberfläche einer Halbleiterschicht (3) gebildet wird, die Resistschicht einem Muster einer Strahlung von einer Art exponiert wird, gegenüber welcher der Resist empfindlich ist, und dann einem Entwicklungsverfahren zur Entfernung eines Teils desselben unterworfen wird, welcher durch das genannte Muster definiert ist, und die genannte Halbleiterschicht durch einen Spalt (9) geätzt wird, der durch die Entfernung des genannten Abschnitts der Resistschicht freigegeben worden ist, um so eine Ausnehmung (10) in der Halbleiterschicht zu bilden, woraufhin Material (12) auf der Halbleiterschicht in der Ausnehmung niedergeschlagen wird, um ein zusätzliches Element der Vorrichtung zu bilden, dadurch gekennzeichnet, daß die Exponierung der Resistschicht in zwei Stufen durchgeführt wird, wobei entsprechende Strahlen (7, 8) der Strahlung verwendet werden, deren Einfallsbereiche auf der Resistschicht benachbart sind, so daß das Entwicklungsverfahren verursacht, daß die Resistschicht, wo sie an den genannten Spalt angrenzt, hinterschnitten wird, in einem größeren Maße in einer Richtung (über der Oberfläche der Halbleiterschicht) als in der entgegengesetzten Richtung; die Resistschicht dann als eine Maske bei der Niederschlagung des genannten Materials (12) verwendet wird, um so das genannte zusätzliche Element exzentrisch bezüglich der genannten Ausnehmung anzuordnen.

*Fig. IA*

*Fig. IB*

*Fig. IC*

*Fig. ID*

## Fig. 1E

## Fig. 1F

## Fig. 1G

# Fig. 2

*Fig. 3*

*Fig. 4*